# FASCICULE DE BREVET EUROPEEN

(11) **EP 1 467 378 B1**
(45) Date de publication et mention de la délivrance du brevet: **18.07.2007**
(21) Numéro de dépôt: 03008452.9
(22) Date de dépôt: 11.04.2003
(51) Int. Cl.: G11C 16/16

(54) **Procédé de mise à jour de données pour mémoire non volatile**
Verfahren zur Aktualisierung eines nicht flüchtigen Speichers
Method for updating a non volatile memory

(43) Date de publication de la demande: 13.10.2004
(73) Titulaire: EM Microelectronic-Marin SA, 2074 Marin (CH)
(72) Inventeur: Hugues, Blangy, 2000 Neuchâtel (CH)
(74) Mandataire: Ravenel, Thierry Gérard Louis

(56) Documents cités:
- EP-A- 0 649 095
- US-B1- 6 414 876
- US-B1- 6 493 807

## Description

La présente invention est relative à un procédé de mise à jour de données pour mémoire non volatile, du type EEPROM ou Flash EEPROM.

De telles mémoires non volatiles sont constituées par des cellules mémoires généralement formées par un transistor à grille flottante pouvant contenir une information binaire. L'information binaire d'une telle cellule mémoire peut prendre une première valeur déterminée, par exemple 0, par piégeage d'électron chaud dans la couche d'oxyde isolant la grille du transistor de la cellule (technologie « stacked gate » ou transistor à grille superposée) ou dans la grille flottante du transistor (technologie « split gate » ou transistor à grille divisée). Cette opération « d'écriture » ou « de programmation » relativement rapide ne nécessite suivant la technologie utilisée, par exemple, que quelques microsecondes. Cette information binaire peut prendre une deuxième valeur déterminée, par exemple 1, par effet tunnel de Fowler-Nordheim qui permet le passage, sans ionisation, d'un électron piégé à travers la couche d'oxyde isolant la grille du transistor (technologie « stacked gate ») ou à partir de la grille flottante (technologie « split gate »). Cette opération « d'effacement » est nettement plus longue que celle précédemment mentionnée, elle peut durer, en considérant la même technologie, par exemple, plusieurs millisecondes.

Suivant les applications dans lesquelles la mémoire est utilisée, cette dernière peut être décomposée en une pluralité de subdivisions mémoires semblables et effaçables indépendamment les unes des autres. Ces subdivisions mémoires ont une taille pouvant varier de celle d'une cellule mémoire à celle d'une page mémoire de plusieurs kilos octets. Dans le cas particulier d'une mémoire Flash, il est important de noter que les opérations de programmation peuvent être effectuées byte par byte, comme pour une EEPROM, mais en revanche, les opérations d'effacement doivent être effectuées blocs par blocs, ce qui nécessite d'avoir à effectuer un effacement de tout un bloc à chaque mise à jour d'un seul byte de ce bloc.

Un procédé conventionnel de mise à jour de données de ce type de mémoire comprend généralement les étapes suivantes :
- effacer une subdivision mémoire réservée pour la sauvegarde de données ;
- sauvegarder les données depuis une subdivision mémoire non réservée à mettre à jour vers la subdivision mémoire réservée effacée précédemment ;
- effacer la subdivision mémoire non réservée à mettre à jour ;
- mettre à jour les données dans la subdivision mémoire effacée à l'étape précédente ;
- répéter les étapes précédentes à chaque nouvelle mise à jour requise.

Préalablement, on notera que l'expression « effacement d'une subdivision mémoire », représente un raccourci de langage fréquemment employé pour signifier « effacement des données contenues dans une subdivision mémoire ».

L'utilisation d'une subdivision mémoire réservée non volatile pour la sauvegarde des données à mettre à jour est nécessaire pour garantir qu'aucune perte de données ne puisse intervenir en cas d'interruption brutale du procédé de mise à jour, due, par exemple, à une coupure d'alimentation. De plus, l'utilisation de la même subdivision mémoire pour contenir les données mises à jour est également nécessaire pour assurer un accès simple et rapide aux données par le système de gestion de la mémoire. Aucun suivi des données, par exemple, par pointeur n'est alors nécessaire.

L'inconvénient principal soulevé par l'utilisation d'une telle subdivision mémoire réservée est l'augmentation de la durée d'exécution du procédé lors de mises à jour effectuées en série. En effet, comme on l'a vu en introduction, les opérations dite « d'effacement » ou de mise à « 1 » des cellules mémoires constituant la subdivision mémoire, est environ 1000 fois plus longue qu'une opération d'écriture. Or le procédé décrit ci-avant nécessite pour chaque mise à jour d'effectuer deux cycles d'effacement, un premier pour réserver un espace mémoire pour la sauvegarde des données, ce qui permet de prévenir un dysfonctionnement quelconque du système mettant en oeuvre le procédé, et un deuxième pour pouvoir effectuer la mise à jour dans la subdivision qui contenait les données avant la mise à jour. Ainsi, le temps d'exécution de ce type de procédé devient rapidement critique notamment en ce qu'il monopolise les ressources du système pendant sa mise en oeuvre.

Le procédé de mise à jour, selon un mode de mise en oeuvre de l'invention, permet non seulement de se prémunir contre des pertes de données en cas de dysfonctionnement lors de sa mise en oeuvre, d'assurer un accès simple et rapide aux données, mais également d'optimiser son temps d'exécution.

Pour cela, le procédé est mis en oeuvre pour une mémoire non volatile décomposée en une pluralité de subdivisions mémoires semblables et effaçables indépendamment les unes des autres parmi lesquelles au moins deux subdivisions mémoires sont réservées pour la mise à jour des données contenues dans chacune desdites subdivisions, le procédé étant caractérisé en ce qu'il comprend les étapes suivantes :
a) effacer une première subdivision mémoire réservée si aucune desdites subdivisions mémoires réservées n'a été préalablement effacée ;
b) sauvegarder les données d'une subdivision mémoire non réservée à mettre à jour dans ladite première subdivision mémoire réservée effacée ou dans une subdivision mémoire réservée préalablement effacée ;
c) effacer simultanément ladite subdivision mémoire non réservée et une deuxième subdivision mémoire réservée ;
d) mettre à jour les données de ladite subdivision mémoire non réservée;
e) réitérer les étapes b) à d) pour toutes autres subdivisions mémoires non réservées à mettre à jour.

L'utilisation d'au moins deux subdivisions mémoires réservées pour la sauvegarde des données permet avantageusement d'utiliser une première subdivision pour stocker les données à mettre à jour et au moins une deuxième subdivision qui est effacée de manière concurrente avec la subdivision à mettre à jour. Ainsi pour toutes les mises à jour ultérieures effectuées une subdivision mémoire réservée est toujours disponible, ce qui permet d'omettre l'étape a), d'effacement d'une subdivision mémoire réservée du procédé. On notera à cet effet, que les deux subdivisions mémoires réservées pour la sauvegarde des données peuvent être remplacées de manière équivalente par des buffers non volatiles externes à la mémoire non volatile contenant les données.

Comme il a été explicité précédemment, le fait de réaliser la mise à jour des données d'une subdivision dans cette même subdivision présente l'avantage de connaître à l'avance l'emplacement de ces données et ne nécessite donc aucun système complexe de suivi des données, comme par exemple, une table non volatile de pointeurs. L'accès aux données est donc simple et rapide.

Néanmoins, en cas d'interruption non prévue du procédé lors de sa mise en oeuvre, afin de pouvoir restaurer aisément les données d'une subdivision en cours de mise à jour telles qu'elles étaient avant, il est avantageux de connaître l'emplacement des données sauvegardées. Dans le cadre de l'art antérieur, la solution était évidente, du fait de l'utilisation d'une unique subdivision réservée. Or, dans le cadre du procédé selon le mode de mise en oeuvre exposé précédemment, il est impératif de faire usage d'au moins deux subdivisions pour obtenir le gain de temps recherché. C'est pourquoi, il est prévu avantageusement de pourvoir ces subdivisions réservées, d'un secteur de contrôle non volatile permettant de déterminer directement à quelle subdivision en cours de mise à jour correspondent les données contenues dans une subdivision réservée.

Afin d'optimiser la procédure de restauration en cas d'interruption, il est avantageusement prévu d'utiliser des moyens de vérification de la bonne exécution du procédé lors de sa mise en oeuvre, du type CRC (« cyclic redundancy check), afin de définir des points d'arrêts permettant de connaître précisément le moment de l'interruption du procédé.

D'autres modes de mise en oeuvre du procédé de mise à jour ainsi que des variantes avantageuses sont exposés dans les revendications dépendantes.

D'autres caractéristiques et avantages de l'invention apparaîtront au cours de la description qui va suivre, donnée uniquement à titre d'exemple et faite en se référant aux dessins annexés sur lesquels :
La figure 1 représente un diagramme des étapes du procédé de mise à jour selon un premier mode de mise en oeuvre de l'invention ;
la figure 1A représente un exemple de détail de l'étape b) du procédé selon le premier mode de mise en oeuvre ;
la figure 1B représente un exemple de détail de l'étape d) du procédé selon le premier mode de mise en oeuvre; et
la figure 2 représente un diagramme des étapes du procédé selon un deuxième mode de mise en oeuvre de l'invention.

Dans la description qui va suivre, le procédé de mise à jour de données selon les différents modes de mise en oeuvre de l'invention, se rapporte à une mémoire non volatile, de préférence du type Flash EEPROM, divisée en une pluralité de subdivisions mémoires (SM) semblables et effaçables indépendamment les unes des autres. Au moins deux subdivisions mémoires sont réservées (SRA, SRB) pour la sauvegarde des données. Cependant, il est envisageable de prévoir de remplacer ces au moins deux subdivisions mémoires réservées internes à la mémoire, par au moins deux buffers externes non volatiles de taille semblable à celle des subdivisions mémoires.

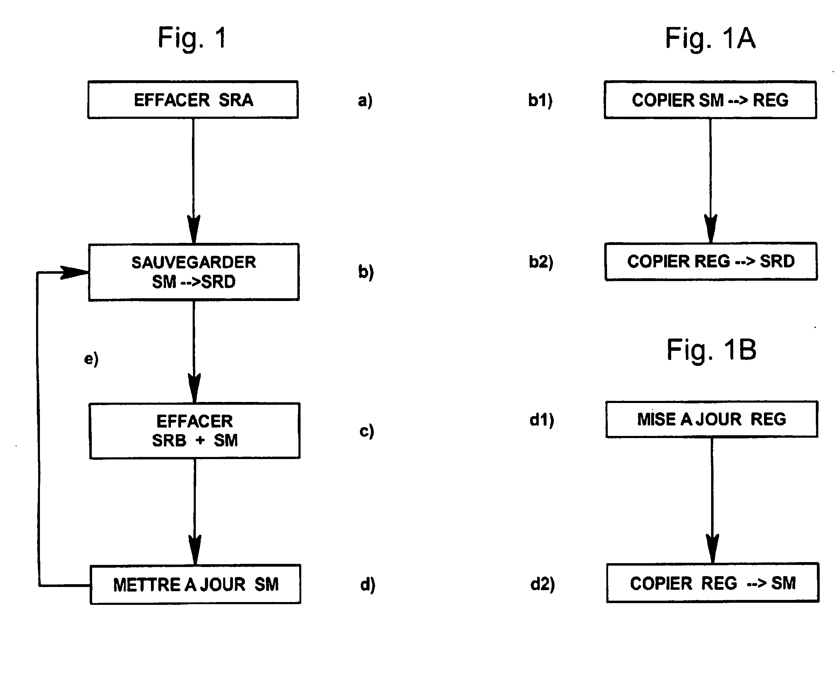

Selon un premier mode de mise en oeuvre du procédé de mise à jour de données, représenté à la figure 1, il est prévu lors d'une première étape a) d'initialisation d'effacer au moins une des subdivisions mémoires réservées (SRA) si aucune d'entre elles n'avait été préalablement effacée. Une fois cette étape d'initialisation effectuée, le procédé permet de gagner pour chaque mise à jour d'une subdivision mémoire un temps d'effacement.

Lors de la deuxième étape b), une des subdivisions mémoires non résevées (SM) dont les données doivent être mises à jour est sauvegardée dans la subdivision mémoire réservée effacée à l'étape précédente ou dans l'une des subdivisions mémoires réservées effacées préalablement, i.e. dans une subdivision mémoire réservée disponible (SRD). Un exemple d'exécution d'une telle étape de sauvegarde peut être effectuée comme représentée à la figure 1A. Dans ce cas, l'étape de sauvegarde est décomposée en une première sous-étape b1) consistant à copier les données à mettre à jour depuis la subdivision mémoire (SM) dans un ou plusieurs registres (REG) suivant la taille de la subdivision, ou dans tout espace mémoire volatile rapidement accessible, le contenu de ses registres étant lors d'une deuxième sous-étape b2) recopiés dans la subdivision mémoire réservée disponible (SRD).

Une fois la deuxième étape b) effectuée, on est assuré que le contenu initial d'avant la mise à jour est récupérable même en cas d'interruption brutale du procédé puisque ce contenu initial est stocké dans une subdivision mémoire réservée non volatile. C'est pourquoi, l'étape consistant à effacer la subdivision mémoire non réservée à mettre à jour (SM) peut être effectuée en toute sécurité.

Dans le cadre de la mise en oeuvre du procédé selon l'invention, il est prévu lors de la troisième étape c), d'effectuer de manière concurrente l'effacement respectivement de la subdivision non réservée à mettre à jour (SM) et d'une subdivision mémoire réservée (SRB) différente de celle contenant les données à mettre à jour. Etant donné que les deux opérations d'effacement sont effectuées simultanément, le temps total de ces deux opérations équivaut au temps d'exécution d'une opération unique d'effacement.

On notera qu'ainsi la subdivision mémoire réservée (SRB) effacée à l'étape c) servira pour la prochaine mise à jour comme subdivision mémoire réservée disponible (SRD).

Une fois l'étape c) effectuée, la subdivision mémoire (SM) à mettre à jour étant effacée, il est possible d'y copier les données mises à jour. L'étape d) de mise à jour des données de cette subdivision mémoire à mettre à jour peut être décomposée en deux sous-étapes d1) et d2), comme représentée à la figure 1 B. La première sous-étape d1) consiste à mettre à jour les données contenues dans les registres (REG) utilisés à l'étape b) et correspondant aux données contenues précédemment par la subdivision non réservée à mettre à jour.

On notera à cet effet que cette étape d1 ) de mise à jour des données contenues dans les registres (REG) peut être effectuée dès que l'étape b2) de recopie de ces données dans la subdivision mémoire réservée disponible (SRD) est terminée et au plus tard avant l'étape d2) qui consiste à recopier les données mises à jour dans les registres depuis ces derniers vers la subdivision mémoire (SM) à mettre à jour. Il est important de noter que l'on utilise avantageusement la même subdivision mémoire pour la mise à jour que celle que l'on a effacée à l'étape c). Ceci permet d'accéder rapidement et simplement aux données mises à jour sans nécessité l'utilisation d'un mécanisme de suivi des données.

Enfin pour toutes les mises à jour ultérieures, l'étape a) n'est plus effectuée du fait qu'au moins une subdivision mémoire réservée a déjà été effacée lors de l'étape c) de la mise à jour précédente. Ainsi lors des mises à jour ultérieures, étape e), seules les étapes b) à d) sont de nouveau effectuées, soit une seule étape d'effacement, l'étape c), ce qui entraîne un net gain de temps lors de l'exécution.

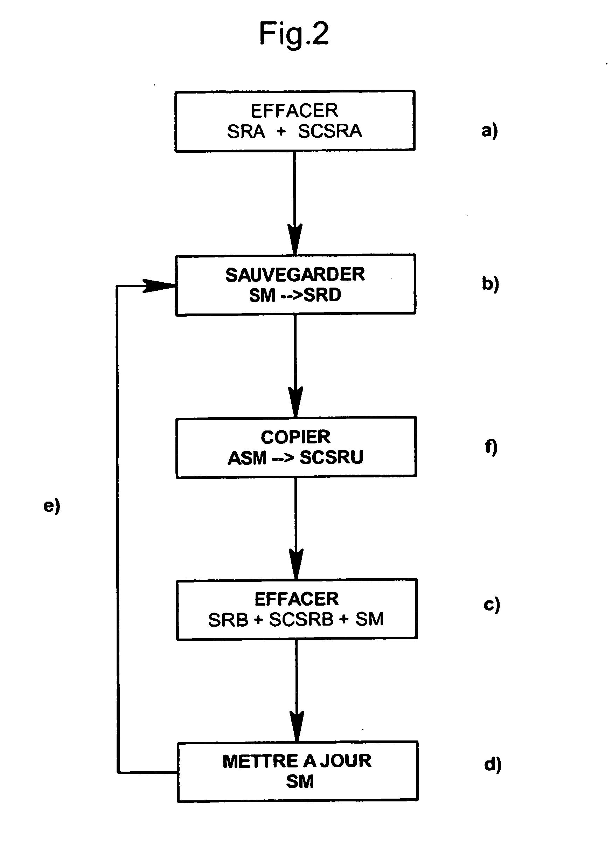

Selon un deuxième mode de mise en oeuvre du procédé, représenté à la figure 2, il est prévu d'associer à chacune des subdivisions mémoires réservées un secteur de contrôle (SCSR). Ce secteur de contrôle permet notamment de déterminer si la subdivision mémoire réservée (SRD) associée est utilisée en ce sens qu'elle contient des données ou si la subdivision réservée (SRD) en question est disponible, en ce sens qu'elle a été préalablement effacée.

Avantageusement, la taille de ce secteur de contrôle dépend du nombre de subdivisions mémoires non réservées (SM) susceptibles d'être mises à jour. Ainsi par exemple, pour une mémoire contenant 62 subdivisions mémoires non réservées, il faudra prévoir pour un secteur de contrôle d'au moins 6 bits, de manière à pouvoir indiquer le numéro de la subdivision à mettre à jour correspondant à son adresse dans la mémoire. Ainsi, la lecture de ce secteur de contrôle permet de savoir non seulement si des données sont contenues dans la subdivision mémoire réservée associée, mais également à quelle subdivision mémoire non réservée à mettre à jour ces données correspondent.

Suivant ce deuxième mode, la première étape a) d'initialisation diffère de celle effectuée dans le cadre du premier mode, en ce qu'elle consiste à effacer non seulement une subdivision mémoire réservée (SRA) si aucune n'a été préalablement effacée, mais aussi à effacer simultanément le secteur de contrôle (SCSRA) associé à cette subdivision mémoire réservée. Ces opérations d'effacement étant effectuées en même temps, il n'en résulte aucune perte de temps par rapport à l'étape a) du premier mode. De plus, cette opération présente l'avantage de pouvoir rapidement et simplement déterminer quelle subdivision mémoire réservée est disponible (SRD) en effectuant une lecture uniquement des secteurs de contrôle (SCSR) des subdivisions mémoires réservées.

L'étape b) est similaire à celle décrite dans le cadre du premier mode de mise en oeuvre du procédé et ne sera donc pas reprise ici.

Une fois l'étape b) effectuée, une étape additionnelle f) est effectuée. Cette étape f) consiste à inscrire une information dans le secteur de contrôle (SCSRU) de la subdivision mémoire réservée utilisée précédemment lors de l'étape b), indiquant l'utilisation de cette dernière. Dans le cas avantageux où la taille du secteur de contrôle est adaptée au nombre de subdivisions mémoires non réservées, l'information inscrite correspond au numéro ou à l'adresse de la subdivision non réservée à mettre à jour (SM).

Ainsi en cas d'interruption brutale du procédé, il suffit simplement de lire le contenu des différents secteurs de contrôle des subdivisions mémoires réservées (SCSR) pour déterminer premièrement, celle qui contient des données qui n'ont pas pu éventuellement être valablement mises à jour et deuxièmement, la subdivision mémoire non réservée à laquelle correspondent les données valides de la subdivision mémoire réservée.

L'étape c) diffère de celle effectuée dans le cadre du premier mode, en ce qu'elle consiste à effacer simultanément non seulement une subdivision mémoire réservée (SRB) différente de celle utilisée pour sauvegarder la subdivision mémoire non réservée à mettre à jour, ainsi que cette dernière, mais aussi le secteur de contrôle (SCSRB) associé à cette autre subdivision mémoire réservée (SRB). Il n'en résulte aucune perte de temps par rapport à l'étape c) du premier mode. De plus, cette opération présente l'avantage de pouvoir rapidement et simplement déterminer quelle subdivision mémoire réservée est disponible (SRD) en vue de la prochaine mise à jour et notamment lors de l'étape b) de cette mise à jour ultérieure.

L'étape d) est similaire à celle décrite dans le cadre du premier mode de mise en oeuvre du procédé et ne sera donc pas reprise ici.

L'étape e) consiste à réitérer toutes les étapes depuis l'étape b) jusqu'à l'étape d) en incluant bien entendu l'étape additionnelle f), pour chaque mise à jour ultérieure.

Selon une variante du deuxième mode de mise en oeuvre du procédé, il est prévu de regrouper tous les secteurs de contrôle (SC) des subdivisions mémoires réservées dans une même zone mémoire afin d'en faciliter la consultation.

Il est bien entendu que d'autres modes de mise en oeuvre du procédé de mise à jour sont envisageables, pour autant que les données soient toujours récupérables même en cas d'interruption du procédé, que l'emplacement de ces données soient toujours déterminables facilement, et que la durée d'une mise à jour soit minimale en ce sens que l'effacement des subdivisions réservées et non réservées soient effectuées simultanément.

On notera encore, qu'il est possible de prévoir une étape additionnelle consistant à programmer tout le secteur de contrôle à 0, pour indiquer que la programmation ou écriture effectuée pour la mise à jour a été effectuée sans erreur.

On notera enfin qu'il est nécessaire de trouver un bon compromis entre le nombre de subdivisions mémoires réservées et non réservées. En effet, il est intéressant d'avoir le minimum de subdivisions mémoires réservées, soit au moins 2, afin d'avoir un espace mémoire utile maximal. En revanche, il est également intéressant d'avoir un nombre important de subdivisions mémoires réservées afin de prolonger le temps de vie de la mémoire, le nombre de cycles d'effacement étant limitée pour chaque subdivision. Un compromis efficace revient à utiliser 1/8 de l'espace mémoire pour les subdivisions mémoires réservées.

## Revendications

1. Procédé de mise à jour de données pour mémoire non volatile décomposée en une pluralité de subdivisions mémoires semblables et effaçables indépendamment les unes des autres parmi lesquelles au moins deux subdivisions mémoires (SRA, SRB) sont réservées pour la mise à jour des données contenues dans chacune desdites subdivisions (SM), le procédé étant **caractérisé en ce qu'**il comprend les étapes suivantes :
a) effacer une première subdivision mémoire réservée (SRA) si aucune desdites subdivisions mémoires réservées n'a été préalablement effacée;
b) sauvegarder les données d'une subdivision mémoire non réservée (SM) à mettre à jour dans ladite première subdivision mémoire réservée effacée (SRD) ou dans une subdivision mémoire réservée préalablement effacée ;
c) effacer simultanément ladite subdivision mémoire non réservée (SM) et une deuxième subdivision mémoire réservée (SRB) ;
d) mettre à jour les données de ladite subdivision mémoire non réservée(SM) ;
e) réitérer les étapes b) à d) pour toutes autres subdivisions mémoires non réservées (SM) à mettre à jour.

2. Procédé selon la revendication 1, pour lequel l'étape b) est décomposée en deux sous-étapes :
b1) copier les données de la subdivision mémoire non réservée (SM) dans des moyens externes de mémorisation volatile(REG) ; puis
b2) copier les données depuis lesdits moyens externes de mémorisation volatile (REG) dans ladite première subdivision mémoire réservée effacée (SRD) ou dans ladite subdivision mémoire réservée préalablement effacée.

3. Procédé selon la revendication 2, pour lequel l'étape d) est décomposée en deux sous-étapes :
d1) mettre à jour les données contenues dans le ou les registres (REG) utilisés à l'étape b) ;
d2) copier les données mises à jour depuis les registres (REG) dans la subdivision mémoire (SM) à mettre à jour.

4. Procédé selon l'une des revendications 1 à 3, pour lequel un secteur de contrôle est associé (SCSR) à chacune des subdivisions mémoires réservées (SR), le procédé étant **caractérisé en ce que**
- lors de l'étape a), un premier secteur de contrôle (SCSRA) associé à la première subdivision mémoire réservée (SRA) effacée, est effacée simultanément si aucune subdivision mémoire réservée n'a été préalablement effacée ;
- lors de l'étape c), un deuxième secteur de contrôle (SCSRB) associé à la deuxième subdivision mémoire réservée (SRB) effacée, est effacée simultanément ;
et **en ce que** le procédé comprend une étape additionnelle f) effectuée entre les étapes b) et c) consistant à :
f) inscrire une information dans le premier secteur de contrôle (SCSRU) de la première subdivision mémoire réservée utilisée précédemment lors de l'étape b), indiquant l'utilisation de cette première subdivision.

5. Procédé selon la revendication 4, pour lequel la taille de la section de contrôle de chacune des subdivisions mémoires réservées est adaptée au nombre de subdivisions mémoires non réservées et en ce que l'étape additionnelle f) consiste alors à :
f) inscrire le numéro ou l'adresse de la subdivision non réservée à mettre à jour (SM) dans le premier secteur de contrôle (SCSRU) de la première subdivision mémoire réservée utilisée précédemment lors de l'étape b).

6. Procédé selon l'une quelconque des revendications précédentes, pour lequel une vérification redondante cyclique (CRC) est mise en oeuvre parallèlement au procédé.

7. Procédé selon l'une quelconque des revendications précédentes, pour lequel le nombre de subdivisions mémoires réservées correspond à 1/8 du nombre de subdivisions mémoires non réservées.

## Claims

1. Method for updating data for a non-volatile memory broken down into a plurality of similar memory subdivisions that can be erased independently of each other and among which at least two memory subdivisions (SRA, SRB) are reserved for updating data contained in each of said subdivisions (SM), the method being **characterised in that** it includes the following steps:
a) erasing a first reserved memory subdivision (SRA) if none of said reserved memory subdivisions has been erased beforehand;
b) saving the data from a non-reserved memory subdivision (SM) to be updated in said first erased reserved memory subdivision (SRD) or in a previously erased reserved memory subdivision;
c) simultaneously erasing said non-reserved memory subdivision (SM) and a second reserved memory subdivision (SRB);
d) updating the data from said non-reserved memory subdivision (SM);
e) reiterating steps b) to d) for all the other non-reserved memory subdivisions (SM) to be updated.

2. Method according to claim 1, wherein the step b) is broken down into two sub-steps:
b1) copying the data from the non-reserved memory subdivision (SM) into external volatile storage means (REG); and
b2) copying the data from said external volatile storage means (REG) into said first erased reserved memory subdivision (SRD) or into said previously erased reserved memory subdivision.

3. Method according to claim 2, wherein step d) is broken down into two sub-steps:
d1) updating the data contained in the external volatile storage means (REG) used in step b);
d2) copying the updated data from the external volatile storage means (REG) into the memory subdivision (SM) to be updated.

4. Method according to any of claims 1 to 3, wherein a checking sector is associated (SCSR) with each of the reserved memory subdivisions (SR), the method being **characterized in that**
- during step a), a first checking sector (SCSRA) associated with the first erased reserved memory subdivision (SRA), is simultaneously erased if none of the reserved memory subdivisions have been erased beforehand;
- during step c), a second checking sector (SCSRB) associated with the second erased reserved memory subdivision (SRB), is simultaneously erased;
and **in that** the method includes an additional step f) carried out between steps b) and c) consisting in:
f) registering a data item in the first checking sector (SCSRU) of the first reserved memory subdivision used previously during step b), indicating the use of said first subdivision.

5. Method according to claim 4, wherein the size of the checking sector of each of the reserved memory subdivisions is adapted to the number of non-reserved memory subdivisions and in that the additional step f) the consists in:
f) registering the number or the address of the non-reserved subdivision to be updated (SM) in the first checking sector (SCSRU) of the first reserved memory subdivision previously used during step b).

6. Method according to any of the preceding claims, wherein a cyclical redundant check (CRC) is implemented parallel to the method.

7. Method according to any of the preceding claims, wherein the number of reserved memory subdivisions corresponds to 1/8^{th} of the number of non-reserved memory subdivisions.

## Patentansprüche

1. Verfahren zum Aktualisieren von Daten für einen nichtflüchtigen Speicher, der in mehrere ähnliche und unabhängig voneinander löschbare Speicherabschnitte zerlegt ist, wovon wenigstens zwei (SRA, SRB) für die Aktualisierung der in jeder dieser Unterabteilungen (SM) enthaltenen Daten reserviert sind, wobei das Verfahren **dadurch gekennzeichnet ist, dass** es die folgenden Schritte umfasst:
a) Löschen eines ersten reservierten Speicherabschnitts (SRA), falls vorher keiner der reservierten Speicherabschnitte gelöscht worden ist;
b) Sichern der Daten eines zu aktualisierenden nicht reservierten Speicherabschnitts (SM) in dem gelöschten ersten reservierten Speicherabschnitt (SRD) oder in einem vorher gelöschten reservierten Speicherabschnitt;
c) gleichzeitiges Löschen des nicht reservierten Speicherabschnitts (SM) und eines zweiten reservierten Speicherabschnitts (SRB);
d) Aktualisieren der Daten des nicht reservierten Abschnitts (SM);
e) Wiederholen der Schritte b) bis d) für alle anderen zu aktualisierenden nicht reservierten Speicherabschnitte (SM).

2. Verfahren nach Anspruch 1, für das der Schritt b) in zwei Unterschritte unterteilt ist:
b1) Kopieren der Daten des nicht reservierten Speicherabschnitts (SM) in externe flüchtige Speichermittel (REG); dann
b2) Kopieren der Daten von den externen flüchtigen Speichermitteln (REG) in den gelöschten ersten reservierten Speicherabschnitt (SRD) oder in den vorher gelöschten reservierten Speicherabschnitt.

3. Verfahren nach Anspruch 2, für das der Schritt d) in zwei Unterschritte unterteilt ist:
d1) Aktualisieren der Daten, die in dem oder den im Schritt b) verwendeten Registern (REG) enthalten sind;
d2) Kopieren der aktualisierten Daten von den Registern (REG) in den zu aktualisierenden Speicherabschnitt (SM).

4. Verfahren nach einem der Ansprüche 1 bis 3, für das jedem der reservierten Speicherabschnitte (SR) ein Steuersektor (SCSR) zugeordnet ist, wobei das Verfahren **dadurch gekennzeichnet ist, dass**
- im Schritt a) ein erster Steuersektor (SCSRA), der dem gelöschten ersten reservierten Speicherabschnitt (SRA) zugeordnet ist, gleichzeitig gelöscht wird, falls im Voraus kein reservierter Speicherabschnitt gelöscht worden ist;
- im Schritt c) ein zweiter Steuersektor (SCSRB), der dem gelöschten zweiten reservierten Speicherabschnitt (SRB) zugeordnet ist, gleichzeitig gelöscht wird;
und dass das Verfahren einen weiteren Schritt f) umfasst, der zwischen den Schritten b) und c) ausgeführt wird und darin besteht:
f) eine Information in den ersten Steuersektor (SCSRU) des im Schritt b) vorher verwendeten ersten reservierten Speicherabschnitts zu schreiben, die die Verwendung dieses ersten Abschnitts anzeigt.

5. Verfahren nach Anspruch 4, für das die Größe des Steuerabschnitts jedes der reservierten Speicherabschnitte an die Anzahl von nicht reservierten Speicherabschnitten angepasst ist und dass der weitere Schritt f) dann darin besteht:
f) die Nummer oder die Adresse des zu aktualisierenden nicht reservierten Abschnitts (SM) in den ersten Steuersektor (SCSRU) des ersten reservierten Speicherabschnitts, der vorher im Schritt b) verwendet wurde, zu schreiben.

6. Verfahren nach einem der vorhergehenden Ansprüche, für das parallel zu dem Verfahren eine zyklische redundante Verifikation (CRC) ausgeführt wird.

7. Verfahren nach einem der vorhergehenden Ansprüche, für das die Anzahl der reservierten Speicherabschnitte 1/8 der Anzahl der nicht reservierten Speicherabschnitte entspricht.
